# EUROPEAN PATENT APPLICATION

(11) **EP 3 327 514 A2**
(43) Date of publication of application: **30.05.2018**
(21) Application number: 17203766.5
(22) Date of filing: 27.11.2017
(51) Int. Cl.: G04B 13/02, B81C 3/00, G04D 3/00

(54) **MECHANICAL COMPONENT, TIMEPIECE, MANUFACTURING METHOD OF MECHANICAL COMPONENT, AND MANUFACTURING METHOD OF TIMEPIECE**

(30) Priority: 29.11.2016 JP 2016230938
(71) Applicant: Seiko Epson Corporation, Tokyo 160-8801 (JP)
(72) Inventor: SHIBUYA, Munehiro, Nagano, 392-8502 (JP); FUNAKAWA, Takeo, Nagano, 392-8502 (JP)
(74) Representative: Hoffmann Eitle

(57) **Abstract**

An escape wheel or a mechanical component including an axle member, and a rotation portion having a rim with tooth portions and a holding portion for holding the axle member. The holding portion has a plurality of projection portions formed to project into a through-hole into which the axle member is inserted. An elastic portion extending from between the projection portions adjacent to each other can be provided between the holding portion and the rim portion.

## Description

### BACKGROUND

### 1. Technical Field

The invention relates to a mechanical component including an axle member and a rotation member, a timepiece using the mechanical component, a manufacturing method of the mechanical component, and a manufacturing method of the timepiece.

### 2. Related Art

A large number of mechanical components represented by gears are mounted on a mechanical timepiece. The mechanical component such as the gear is fixed (held) by an axle member inserted into a through-hole (holding portion) disposed around a rotation member whose outer periphery has a plurality of tooth portions. In the related art, the mechanical component is formed by machining a metal material. However, a base material containing silicon has been recently used as a material of a timepiece mechanical component. The mechanical component made of silicon is lighter than the mechanical component made of metal. In this regard, silicon is suitably used as a component material having a reduced inertial force. Accordingly, it is expected that energy transmission efficiency is improved. In addition, silicon is more freely used in forming a shape when photolithography or an etching technology is used, thereby providing an advantage in that processing accuracy can be improved.

For example, Japanese Patent No.5,892,181 discloses a technology as follows. In order to fix the mechanical component by inserting the axle member into the through-hole of the rotation member formed of the base material containing silicon, a metal film (stress relaxation layer) is formed on an inner wall surface (inner peripheral surface) of the through-hole.

However, a manufacturing method of the mechanical component disclosed in Japanese Patent No. 5,892,181 has the following problem. It is necessary to prepare a step for forming the metal film on the inner wall surface of the through-hole of the rotation member. Consequently, the step is complicated, thereby causing a possibility of increased manufacturing cost.

In a case where there is no reinforcement measure for forming the metal film on the inner wall surface of the through-hole of the rotation member, there is a possibility that the rotation member may be damaged starting from a periphery of the through-hole due to stress applied when the axle member is inserted into the through-hole (holding portion) of the rotation member. However, Japanese Patent No. 5,892,181 does not disclose any measure for relaxing the stress applied to the rotation member when the axle member is inserted into the rotation member.

### SUMMARY

An advantage of some aspects of the invention is to solve at least a part of the problems described above, and the invention can be implemented as the following forms or application examples.

### Application Example 1

A mechanical component according to this application example includes an axle member, and a rotation member that has a holding portion for holding the axle member, and a rim portion having a plurality of tooth portions. The holding portion has a plurality of projection portions formed to project into a through-hole into which the axle member is inserted. An elastic portion extending from between the projection portions adjacent to each other is provided between the holding portion and the rim portion.

According to this configuration, stress applied to the holding portion when the axle member is held by the plurality of projection portions formed to project into the through-hole into which the axle member in the holding portion is inserted is relaxed by the elastic portion extending to the rim portion from between the projection portions adjacent to each other. Accordingly, damage such as breakage of the projection portion can be suppressed, and elasticity of the elastic portion enables the projection portion of the holding portion to obtain holding power for holding the axle member.

Therefore, it is possible to provide the mechanical component in which the axle member is held in the rotation member by using suitable holding power while the breakage of the holding portion of the rotation member is suppressed.

### Application Example 2

A mechanical component according to this application example includes an axle member, and a rotation member that has a rim portion having a plurality of tooth portions. The rotation member has plurality of elastic portions which extend from the rim portion so as to hold the axle member.

According to this configuration, when the axle member is held by a holding structure having the plurality of elastic portions extending from the rim portion, the stress applied to the holding portion of the rotation member is relaxed by the elasticity of the elastic portion. Accordingly, damage such as breakage of the holding portion of the rotation member can be suppressed, and the holding power for holding the axle member can be obtained by the elasticity of the elastic portion.

Therefore, it is possible to provide the mechanical component in which the axle member is held in the rotation member by using the suitable holding power while the breakage of the holding portion of the rotation member is suppressed.

### Application Example 3

In the mechanical component according to the application example, the elastic portion is formed of the same material as that of the rotation member.

According to this configuration, the rotation member can be efficiently formed by processing one base material. Accordingly, the mechanical component having the above-described advantageous effect can be provided at low cost.

### Application Example 4

In the mechanical component according to the application example, the same material contains silicon.

The mechanical component formed through processing of the material containing silicon by using photolithography and etching is lighter in weight than a metallic mechanical component, and thus, has an advantage in that the shape is more freely designed and processing accuracy is improved.

### Application Example 5

In the mechanical component according to the application example, the elastic portion is formed in an arc shape.

According to this application example, the elastic portion is likely to be deformed since the elastic portion is formed in the arch shape. Accordingly, when the axle member is held, the stress applied to the holding portion can be relaxed by the deformed elastic portion.

### Application Example 6

In the mechanical component according to the application example, the elastic portion has a bend portion.

According to this application example, the elastic portion between the bend portion and the rim portion (that is, the elastic portion ahead of the bend portion) is deformed by the bend portion belonging to the elastic portion. Accordingly, when the axle member is held, the stress applied to the holding portion can be relaxed by the elastic portion.

### Application Example 7

In the mechanical component according to the application example, a front surface of the rotation member has an oxide film formed thereon.

The silicon oxide film formed on the front surface of the rotation member formed of the material containing silicon can improve mechanical strength of the mechanical component in which the axle member is fixed to the rotation member.

In addition, the silicon oxide film is formed on the front surface of the rotation member in which the axle member is inserted into the holding portion of the rotation member formed of the material containing silicon. In this manner, a clearance between the holding portion of the rotation member and the axle member is partially filled with the silicon oxide film formed on the inner wall (surface on a side where the projection portion comes into contact with the axle member) of the through-hole of the holding portion. Accordingly, it is possible to provide the mechanical component in which the axle member is firmly fixed to the rotation member.

In addition, the silicon oxide film formed through the oxidation treatment is formed to have a substantially uniform thickness regardless of a size of the clearance between the holding portion and the axle member, on the inner wall (surface on the side where the projection portion comes into contact with the axle member) of the through-hole of the holding portion. Accordingly, the axle member can be fixed to the rotation member in a state where the center of the holding portion and the axial center of the axle member coincide with each other.

### Application Example 8

A timepiece according to this application example includes a movement assembled using the mechanical component according to the application example for any one of a barrel wheel, wheel & pinions, an escape wheel, a pallet fork, and a balance.

According to this application example, the timepiece includes the movement assembled using the mechanical component according to any one of the application examples. Accordingly, the rotation member and the axle member are firmly fixed to each other in a state where the center of the holding portion of the rotation member and the axial center of the axle member coincide with each other. The movement in which energy transmission efficiency and operation accuracy are improved can be configured to include the mechanical component which is lighter in weight than a metallic mechanical component and for which the inertial force is minimized.

Therefore, it is possible to provide the more accurate timepiece which achieves excellent reliability and durability.

### Application Example 9

A manufacturing method of a mechanical component according to this application example includes preparing an axle member, performing etching on a base material containing silicon, and forming a rotation member that has a holding portion having a plurality of projection portions arranged so as to project to a through-hole into which the axle member is inserted, a rim portion having a plurality of tooth portions, and an elastic portion extending from between the projection portions adjacent to each other, between the holding portion and the rim portion, and positioning the axle member by inserting the axle member into the holding portion of the rotation member.

The mechanical component formed through processing of the material containing silicon by using photolithography and etching is lighter in weight than a metallic mechanical component, and thus, has an advantage in that the shape is more freely designed and processing accuracy is improved.

According to this application example, when the axle member is held by the plurality of projection portions formed to project into the through-hole to which the axle member is inserted in the holding portion, the stress applied to the holding portion is relaxed by the elasticity of the elastic portion extending to the rim portion from between the projection portions adjacent to each other. Accordingly, damage such as breakage of the projection portion can be suppressed, and it is possible to form the rotation member in which the projection portion of the holding portion can obtain the holding power for holding the axle member by using the elasticity of the elastic portion.

Therefore, it is possible to manufacture the mechanical component in which the axle member is held in the rotation member by using the suitable holding power while the breakage of the holding portion of the rotation member is suppressed.

### Application Example 10

A manufacturing method of a mechanical component according to this application example includes preparing an axle member, performing etching on a base material containing silicon, and forming a rotation member that has a rim portion having a plurality of tooth portions, and a plurality of elastic portions extending from the rim portion so as to hold the axle member, and positioning the axle member by inserting the axle member into the holding portion of the rotation member.

According to this manufacturing method, when the axle member is held by the holding portion configured to include the plurality of elastic portions extending from the rim portion, the stress applied to the holding portion of the rotation member is relaxed by the elasticity of the elastic portion. Accordingly, damage such as breakage of the holding portion of the rotation member can be suppressed, and it is possible to form the rotation member in which the holding power for holding the axle member can be obtained by using the elasticity of the elastic portion.

Therefore, it is possible to provide the mechanical component in which the axle member is held in the rotation member by using the suitable holding power while the breakage of the holding portion of the rotation member is suppressed.

### Application Example 11

The manufacturing method of a mechanical component according to the application example further includes performing oxidation treatment after the positioning.

According to this application example, the manufacturing method includes performing the oxidation treatment on the front surface of the rotation member after the positioning is performed by inserting the axle member into the holding portion of the rotation member formed of the base material containing silicon. Accordingly, a clearance between the holding portion of the rotation member and the axle member is filled with the silicon oxide film formed on the inner wall (surface on the side where the projection portion comes into contact with the axle member) of the through-hole of the holding portion. In this manner, it is possible to provide the mechanical component in which the axle member is firmly fixed to the rotation member.

In addition, the silicon oxide film formed through the oxidation treatment is formed to have a substantially uniform thickness regardless of a size of the clearance between the holding portion and the axle member, on the inner wall (surface on the side where the projection portion comes into contact with the axle member) of the through-hole of the holding portion. Accordingly, the axle member can be fixed to the rotation member in a state where the center of the holding portion and the axial center of the axle member coincide with each other.

In addition, the silicon oxide film formed on the front surface of the rotation member formed of the material containing silicon can improve mechanical strength of the mechanical component in which the axle member is fixed to the rotation member.

### Application Example 12

In the manufacturing method of a mechanical component according to the application example, in performing the oxidation treatment, thermal oxidation treatment is performed.

According to the thermal oxidation treatment in this application example, it is possible to form a sufficient thick and dense silicon oxide film within a relatively short time. Accordingly, it is possible to efficiently manufacture the mechanical component in which the axle member is firmly fixed to the rotation member and the mechanical strength is improved.

### Application Example 13

In the manufacturing method of a mechanical component according to the application example, the thermal oxidation treatment is performed using a steam oxidation method.

According to this application example, for example, the steam oxidation method enables the silicon oxide film to have a higher growth rate compared to a dry oxidation method. Accordingly, the silicon oxide film can be more efficiently formed, and the axle member can be fixed to the rotation member.

### Application Example 14

In the manufacturing method of a mechanical component according to the application example, the axle member is formed of tantalum (Ta) or tungsten (W).

According to this application example, tantalum or tungsten has sufficient rigidity as the axle member, and has sufficient heat resistance against the temperature of the oxidation treatment such as the thermal oxidation treatment performed at a high temperature of 1,000°C or higher. Moreover, tantalum or tungsten is a material allowing satisfactory workability. Therefore, tantalum or tungsten can be suitably used as the material of the axle member.

### Application Example 15

In the manufacturing method of a mechanical component according to the application example, the axle member is formed of a material containing silicon.

According to this application example, through performing the oxidation treatment, the silicon oxide film is formed not only on the front surface of the rotation member, but also on the front surface of the axle member. Accordingly, the axle member can be more firmly fixed to the through-hole of the rotation member within a shorter time.

### Application Example 16

A manufacturing method of a timepiece according to this application example includes assembling a movement by using a mechanical component manufactured using the manufacturing method of the mechanical component according to the application example for any one of a barrel wheel, wheel & pinions, an escape wheel, a pallet fork, and a balance.

According to this application example, the manufacturing method includes assembling the movement by using the mechanical component manufactured using the manufacturing method of the mechanical component according to any one of the application examples. Accordingly, the rotation member and the axle member are firmly fixed to each other in a state where the center of the holding portion of the rotation member and the axial center of the axle member coincide with each other. The movement in which energy transmission efficiency and operation accuracy are improved can be configured to include the mechanical component which is lighter in weight than a metallic mechanical component and for which the inertial force is minimized.

Therefore, it is possible to manufacture the more accurate timepiece which achieves excellent reliability and durability.

### BRIEF DESCRIPTION OF THE DRAWINGS

The invention will be described with reference to the accompanying drawings, wherein like numbers reference like elements.
Fig. 1 is a plan view of a front side of a movement of a timepiece according to Embodiment 1.
Fig. 2 is a plan view of an escapement mechanism of the movement.
Fig. 3 is a perspective view of the escapement mechanism.
Fig. 4 is a sectional view taken along line A-A in Fig. 2.
Fig. 5 is a plan view of an escape gear portion serving as a rotation member.
Fig. 6 is a flowchart illustrating a manufacturing method of an escape wheel serving as a mechanical component.
Fig. 7A is a view for describing a gear portion forming step, and is a sectional view corresponding to a gear portion in Fig. 4.
Fig. 7B is a view for describing the gear portion forming step, and is a sectional view corresponding to the gear portion in Fig. 4.
Fig. 7C is a view for describing the gear portion forming step, and is a sectional view corresponding to the gear portion in Fig. 4.
Fig. 7D is a view for describing the gear portion forming step, and is a sectional view corresponding to the gear portion in Fig. 4.
Fig. 8 is a plan view illustrating an escape wheel serving as a mechanical component according to Embodiment 2.
Fig. 9 is a plan view illustrating an escape wheel according to Modification Example 1.
Fig. 10 is a plan view illustrating an escape wheel according to Modification Example 2.
Fig. 11 is a plan view illustrating an escape wheel according to Modification Example 3.

### DESCRIPTION OF EXEMPLARY EMBODIMENTS

Hereinafter, embodiments according to the invention will be described with reference to the drawings. In the embodiments, an example will be described in which an escape wheel which is one of gears configuring timepiece components in a movement of a mechanical timepiece is employed as an example of a mechanical component according to the invention. In addition, in each drawing below, in order to allow each layer or each member to have a recognizable size, each layer or each member is illustrated using a scale different from the actual scale, in some cases.

### Embodiment 1

### Mechanical Timepiece

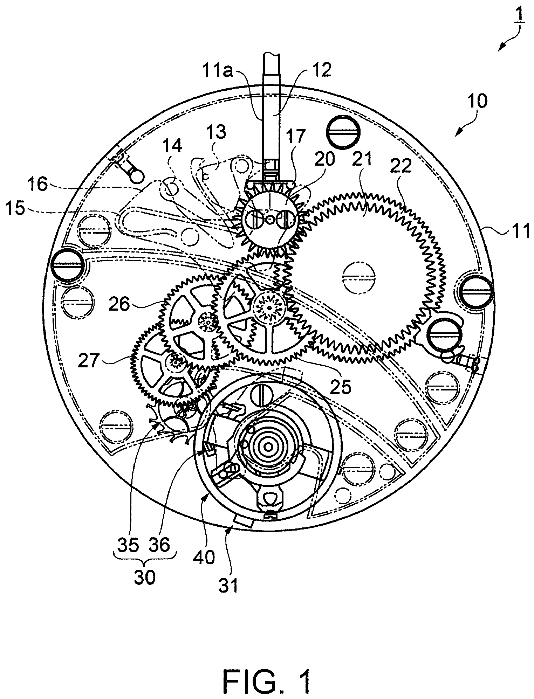

First, a mechanical timepiece 1 will be described. Fig. 1 is a plan view of a front side of the movement of the mechanical timepiece serving as the timepiece according to the present embodiment.

As illustrated in Fig. 1, the mechanical timepiece 1 according to the embodiment is configured to include a movement 10 and a casing (not illustrated) for accommodating the movement 10.

The movement 10 has a main plate 11 configuring a substrate. A dial (not illustrated) is disposed on a rear side of the main plate 11. A train wheel incorporated on a front side of the movement 10 is referred to as a front train wheel, and a train wheel incorporated on a rear side of the movement 10 is referred to as a rear train wheel.

A winding stem guide hole 11a is formed in the main plate 11, and a winding stem 12 is rotatably incorporated therein. The winding stem 12 is positioned in an axial direction by a switching device having a setting lever 13, a yoke 14, a yoke spring 15, and a setting lever jumper 16. In addition, a winding pinion 17 is rotatably disposed in a guide axle portion of the winding stem 12.

Based on this configuration, if the winding stem 12 is rotated in a state where the winding stem 12 is located at a first winding stem position (zero stage) closest to the inside of the movement 10 along a rotation axis direction, the winding pinion 17 is rotated via the rotation of a clutch wheel (not illustrated). Then, as the winding pinion 17 is rotated, a crown wheel 20 meshing with the winding pinion 17 is rotated. Then, as the crown wheel 20 is rotated, a ratchet wheel 21 meshing with the crown wheel 20 is rotated. As the ratchet wheel 21 is rotated, a mainspring (power source) (not illustrated) accommodated in a barrel wheel 22 is wound up.

In addition to the above-described barrel wheel (mechanical component) 22, the front train wheel of the movement 10 is configured to include a center wheel & pinion (mechanical component) 25, a third wheel & pinion (mechanical component) 26, and a second wheel & pinion (mechanical component) 27 which are so-called wheels & pinions, and fulfills a function of transmitting a rotation force of the barrel wheel 22. In addition, the front side of the movement 10 has an escapement mechanism 30 and a speed control mechanism 31 for controlling the rotation of the front train wheel.

The center wheel & pinion 25 serves as a gear meshing with the barrel wheel 22. The third wheel & pinion 26 serves as a gear meshing with the center wheel & pinion 25. The second wheel & pinion 27 serves as a gear meshing with the third wheel & pinion 26.

The escapement mechanism 30 controls the rotation of the above-described front train wheel, and includes an escape wheel (mechanical component) 35 meshing with the second wheel & pinion 27, and a pallet fork (mechanical component) 36 which regularly rotates the escape wheel 35 by allowing escapement of the escape wheel 35.

The speed control mechanism 31 controls the speed of the above-described escapement mechanism 30, and includes a balance (mechanical component) 40.

### Escapement Mechanism

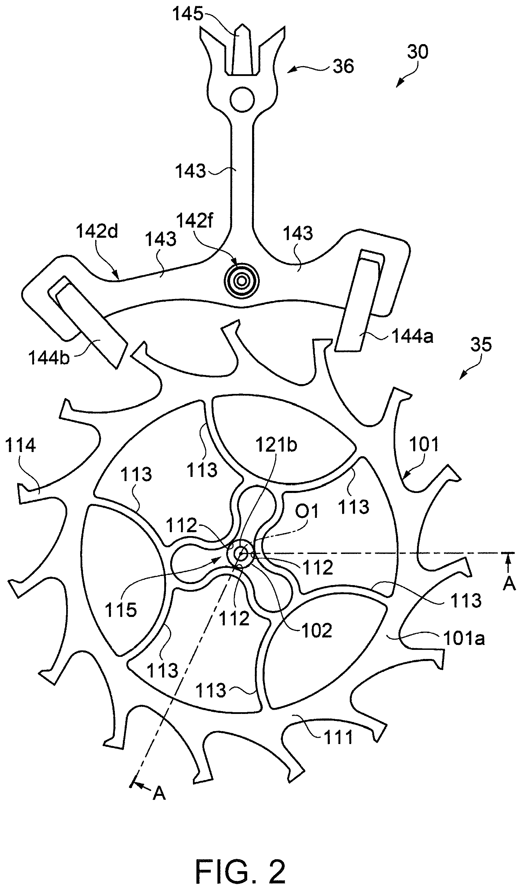

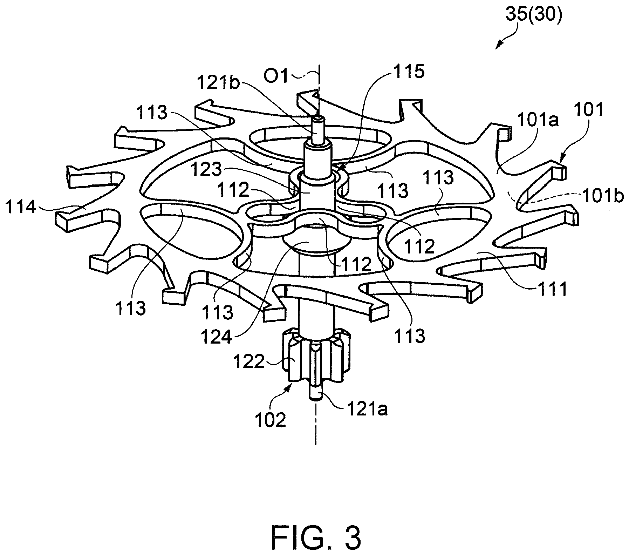

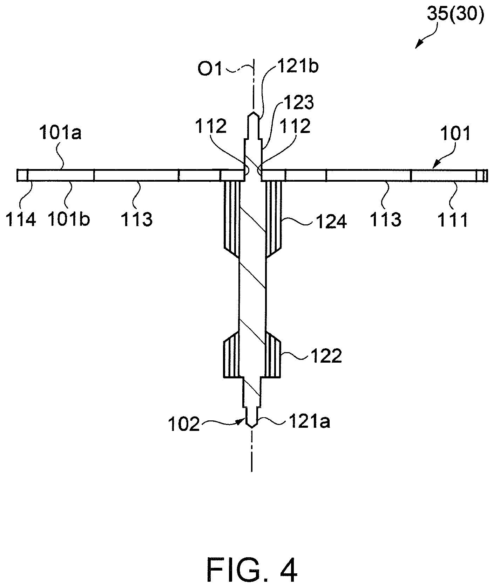

Next, the escapement mechanism 30 of the above-described movement 10 will be described in more detail. Fig. 2 is a plan view of the escapement mechanism 30. Fig. 3 is a perspective view of the escapement mechanism 30. Fig. 4 is a sectional view taken along line A-A in Fig. 2.

As illustrated in Figs. 2 to 4, the escape wheel 35 of the escapement mechanism 30 includes an escape gear portion 101 serving as a rotation member, and an axle member (rotation axle) 102 which is coaxially (axis O1 fixed to the escape gear portion 101. In the following description, a direction extending along the axis O1 of the escape gear portion 101 and the axle member 102 is simply referred to as an axial direction, a direction orthogonal to the axis O1 is referred to as a radial direction, and a direction turning around the axis O1 is referred to as a circumferential direction.

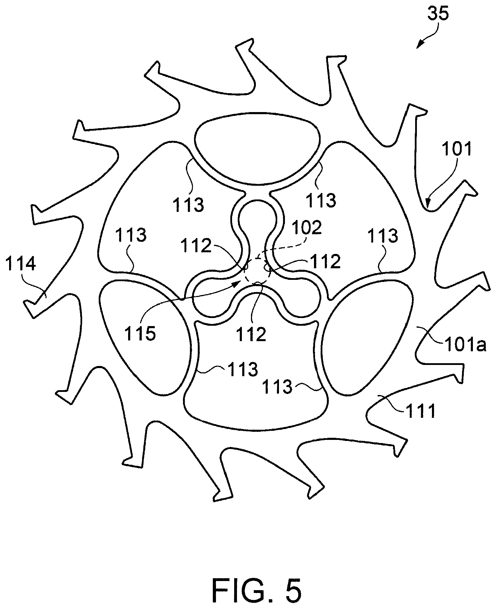

Fig. 5 is a plan view of the escape gear portion 101 serving as the rotation member.

As illustrated in Figs. 2 to 5, the escape gear portion 101 is made of a material having a crystal orientation such as mono-crystalline silicon, or a material such as metal. A front surface 101a serving as one surface and a rear surface 101b serving as the other surface on the side opposite to one surface are formed to be a flat surface, and have a plate shape having a uniform thickness over the entire surface. Specifically, the escape gear portion 101 has a rim portion 111 surrounding the escape gear portion 101, a holding portion 115 at the center, and a plurality of spoke-like elastic portions 113 connecting the rim portion 111 and the holding portion 115 to each other.

On an outer peripheral surface of the rim portion 111, a plurality of the tooth portions 114 formed in a special hook shape are disposed so as to protrude outward in the radial direction. Pallets 144a and 144b of a pallet fork 36 (to be described later) come into contact with each distal end of the plurality of tooth portions 114.

As illustrated in Figs. 3 to 5, the holding portion 115 has a plurality of projection portions 112 formed to project into the through-hole into which the axle member 102 is inserted. The holding portion 115 according to the embodiment has three projection portions 112, and the axle member 102 is held by the projection portions 112.

The respective elastic portions 113 extend radially in a dually divided arc shape toward the inner peripheral edge of the rim portion 111 from between the projection portions 112 adjacent to each other in the holding portion 115, and connect the rim portion 111 and the holding portion 115 to each other.

The axle member 102 has tenon portions 121a and 121b located in both end portions in the axial direction, and an escape pinion portion 122 meshing with the gear portion of the above-described second wheel & pinion 27.

In the tenon portions 121a and 121b, one end tenon portion 121a located on one end side in the axial direction is rotatably supported by a train wheel bridge (not illustrated), and the other end tenon portion 121b located on the other end side in the axial direction is rotatably supported by the above-described main plate 11.

The escape pinion portion 122 is formed closer to one end tenon portion 121a in the axle member 102. Then, the escape pinion portion 122 meshes with the second wheel & pinion 27 (refer to Fig. 1). In this manner, a rotation force of the second wheel & pinion 27 is transmitted to the axle member 102, and the escape wheel 35 is rotated.

A press-fitted axle portion 123 is formed to have a diameter larger than that of the above-described respective tenon portions 121a and 121b, and is inserted into the through-hole having the plurality of projection portions 112 disposed in the holding portion 115 of the escape gear portion 101, from the rear surface 101b side. In this case, the press-fitted axle portion 123 is disposed inside the holding portion 115 in a state where the press-fitted axle portion 123 partially protrudes from the escape gear portion 101 toward the other end side in the axial direction.

In addition, a flange portion 124 protruding outward in the radial direction is formed between the escape pinion portion 122 and the press-fitted axle portion 123 in the axle member 102. The flange portion 124 has a diameter larger than that of an opening of the circumscribed circle passing through the top of on the rear surface 101b side of the three projection portions 112 projecting into the through-hole of the holding portion 115. An end surface located on the other end side in the axial direction is in contact with the rear surface 101b of the projection portion 112. Here, the diameter of the circumscribed circle passing through the top of the three projection portions 112 projecting into the through-hole of the holding portion 115 is designed to be smaller than the diameter of the cross section obtained by cutting the press-fitted axle portion 123 of the axle member 102 in the direction orthogonal to the axis O1.

In the escape wheel 35 configured in this way, the plurality of tooth portions 114 mesh with the pallet fork 36 (refer to Fig. 2). The pallet fork 36 includes a pallet fork body 142d formed in a T-shape by three pallet beams 143, and a pallet staff 142f. The pallet fork body 142d is configured to be pivotable by the pallet staff 142f serving as the axis. In the pallet staff 142f, both ends thereof are respectively supported so as to be pivotable with respect to the above-described main plate 11 and a pallet bridge (not illustrated).

The pallets 144a and 144b are disposed in respective distal ends of the two pallet beams 143 in the three pallet beams 143. A pallet receptacle 145 is attached to the distal end of the remaining pallet beam 143. The pallets 144a and 144b are ruby formed in a quadrangular prism shape, and fixedly adhere to the pallet beam 143 by using an adhesive.

When the pallet fork 36 configured in this way pivots around the pallet staff 142f, the pallet 144a or the pallet 144b comes into contact with the distal end of the tooth portion 114 of the escape wheel 35. In addition, at this time, the pallet beam 143 having the pallet receptacle 145 attached thereto comes into contact with a banking pin (not illustrated), thereby preventing the pallet fork 36 from pivoting any further in the same direction. As a result, the rotation of the escape wheel 35 is temporarily stopped.

### Manufacturing Method of Escape Wheel

Next, a manufacturing method of escape wheel 35 serving as the mechanical component will be described.

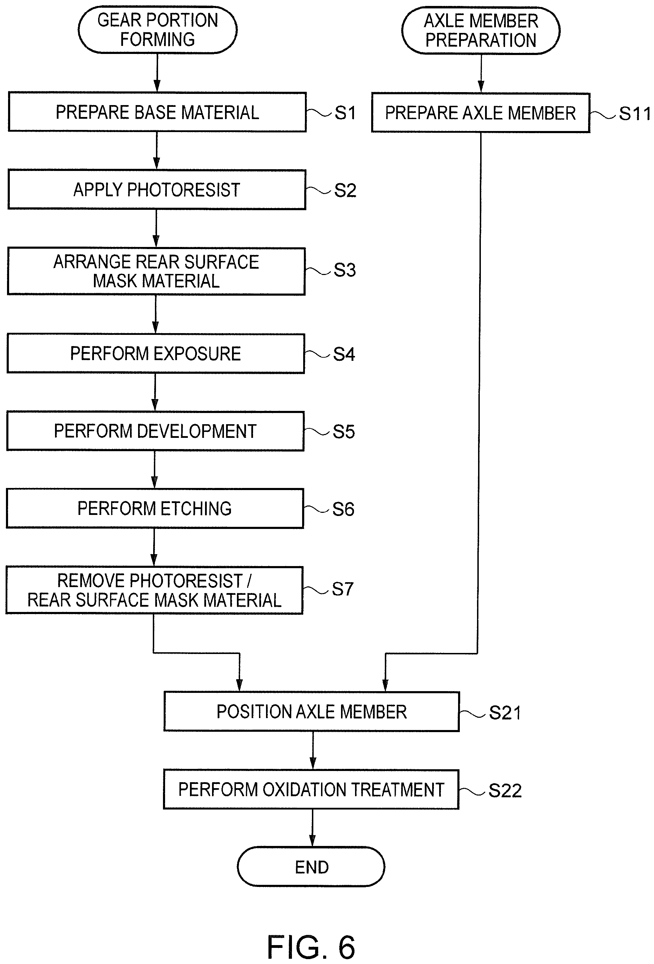

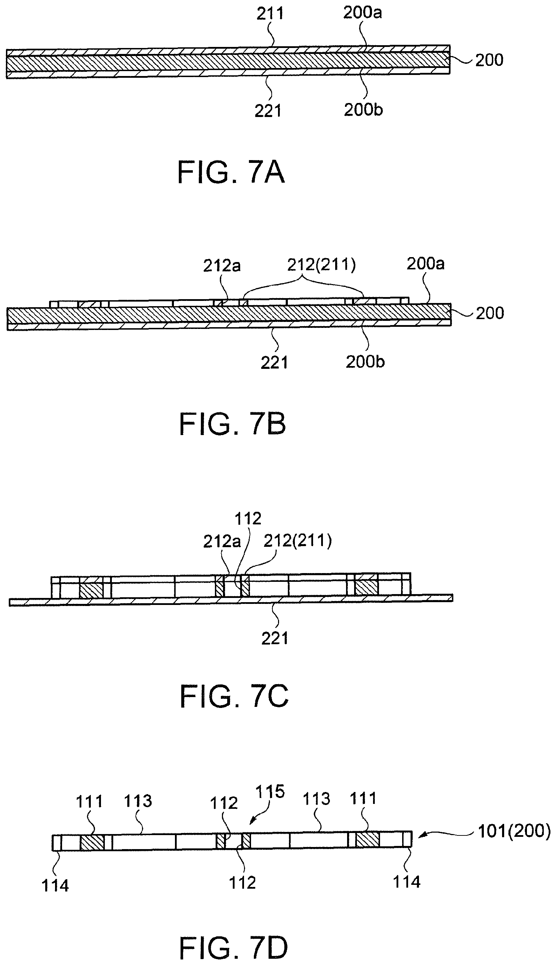

Fig. 6 is a flowchart illustrating the manufacturing method of the above-described escape wheel 35 serving as the mechanical component. Figs. 7A to 7D are views for describing a step of preparing the escape wheel 35, and are sectional views corresponding to the gear portion 101 serving as the rotation member in Fig. 4.

In Fig. 6, the manufacturing method of the escape wheel 35 according to the embodiment includes a step of forming the gear portion (escape gear portion) 101 serving as the rotation member, a step of preparing the axle member 102, and a step of assembling the gear portion 101 and the axle member 102 which are prepared through the step.

In the step of forming the gear portion 101, a base material (wafer) 200 containing silicon is first prepared (Step S1).

Next, as illustrated in Fig. 7A, a photoresist 211 is applied to a front surface 200a of a base material 200 by using a spin coating method or a spray coating method, for example (Step S2 in Fig. 6). A rear surface mask material 221 is disposed on a rear surface 200b of the base material 200 (Step S3 in Fig. 6). The photoresist 211 can employ any one of negative type and positive type materials. In addition, the rear surface mask material 221 has a mask function capable of protecting the rear surface 200b of the base material 200 from being etched when the etching is performed on the base material 200 in a step of etching the base material 200 (to be described later). After the etching step, a resin material having a reliably removable property is selected and employed for the rear surface mask material 221.

Each of the photoresist 211 and the rear surface mask material 221 which are applied to the base material 200 is cured at a predetermined temperature. However, in a case where there is a great difference between a curing condition of the photoresist 211 and a curing condition of the rear surface mask material 221, the photoresist 211 and the rear surface mask material 221 are separately cured. If the curing condition of the photoresist 211 and the curing condition of the rear surface mask material 221 are the same as or approximate to each other, a curing step is performed at the same time. In this manner, the step can be efficiently improved.

The step of applying the photoresist 211 and the step of applying the rear surface mask material 221 may be configured so that the order is reversed for the convenience of setting the step order in view of the curing condition of each resin material.

Next, as illustrated in Fig. 7B, the photoresist 211 is exposed using photolithography technology (Step S4 in Fig. 6). Thereafter, development is performed (Step S5 in Fig. 6) so as to form a photoresist pattern 212 serving as a mask (etching mask) corresponding to an outer shape in a plan view of the escape gear portion 101.

Next, as illustrated in Fig. 7C, etching is performed on the base material 200 by using the above-described photoresist pattern 212 as the mask, thereby forming each outer shape of the projection portion 112 projecting to the through-hole of the holding portion 115, the elastic portion 113, the rim portion 111, and the escape gear portion 101 (Step S6 in Fig. 6). Specifically, deep reactive ion etching (DRIE) is performed and etching is performed so as to penetrate the base material 200 in a thickness direction. In this manner, the outer shape of the escape gear portion 101 can be obtained. Here, an inner wall (surface on the side holding the axle member 102 of the projection portion 112) of the penetrating portion of the through-hole of the holding portion 115 formed by an opening 212a of the photoresist pattern 212 is protected by the rear surface mask material 221 formed on the rear surface 200b of the base material 200. Accordingly, the etching is not performed from the rear surface 200b, and an inner surface shape of the penetrating portion is not changed.

Subsequently, as illustrated in Fig. 7D, a removal step of removing the photoresist pattern 212 obtained by the photoresist 211 and the rear surface mask material 221 is performed (Step S7 in Fig. 6). In this manner, the above-described escape gear portion 101 is obtained, and a step of forming the escape gear portion 101 is completed. The resin can be removed by means of wet etching using fuming nitric acid or organic solvent capable of dissolving/separating the photoresist pattern 212 (photoresist 211) and the rear surface mask material 221, or by means of oxygen plasma ashing.

Apart from the step of forming the escape gear portion 101, the axle member 102 separately formed by means of machining such as cutting or grinding through the step of preparing the axle member 102 is prepared (Step S11 in Fig. 6). It is preferable that the axle member 102 has sufficient rigidity as an axle body. The axle member 102 is preferably formed of tantalum (Ta) or tungsten (W) which is a material having sufficient heat resistance against the temperature of the oxidation treatment such as the thermal oxidation treatment performed at a high temperature of 1,000°C or higher in the oxidation treatment described later. Tantalum or tungsten is a material which is excellent in rigidity and heat resistance as described above. In addition, tantalum or tungsten is a material allowing satisfactory workability in cutting and grinding. Accordingly, tantalum or tungsten is particularly suitable as the material of the axle member 102.

Next, in Fig. 6, a positioning step is performed as follows. The axle member 102 prepared in the above-described preparation step is inserted into the through-hole portion into which the plurality of projection portions 112 project in the holding portion 115 of the escape gear portion serving as the rotation member 101 formed by the above-described forming step (Step S21).

As described above, the diameter of the circumscribed circle passing through the top of the three projection portions 112 projecting into the through-hole of the holding portion 115 is designed to be smaller than the diameter of the cross section obtained by cutting the press-fitted axle portion 123 of the axle member 102 in the direction orthogonal to the axis O1 (refer to Figs. 3 and 4). Therefore, if the axle member 102 is inserted into the through-hole portion into which the plurality of projection portions 112 of the holding portion 115 project, the stress is applied to the holding portion 115 so that the plurality of the projection portions 112 coming into contact with the axle member 102 are spread outward. The escape gear portion 101 according to the embodiment has the elastic portion 113 extending to the rim portion 111 from between the projection portions 112 adjacent to each other, between the plurality of projection portions 112 of the holding portion 115 and the rim portion 111. Accordingly, the stress applied to the projection portion 112 is relaxed by the elasticity of the elastic portion, and the holding power for holding the axle member 102 can be obtained by the elasticity of the elastic portion 113. Therefore, while suppressing damage such as breakage of the escape gear portion 101 which is caused by the stress applied to the projection portion 112 when the axle member 102 is inserted into the holding portion 115, the axle member 102 can be positioned in the escape gear portion 101 by holding the axle member 102 with the suitable holding power.

As described above, the axle member 102 is positioned by being inserted into the holding portion 115 of the escape gear portion 101. Thereafter, oxidation treatment for forming a silicon oxide film formed of silicon dioxide (SiO₂) is performed on the front surface of the escape gear portion 101 serving as the rotation member (Step S22). As the oxidation treatment, it is preferable to perform thermal oxidation treatment performed at a high temperature of 1,000°C or higher, for example. According to the thermal oxidation treatment, it is possible to form a dense silicon oxide film having a predetermined thickness within a relatively short time. In the embodiment, the thermal oxidation treatment using a steam oxidation method is performed. According to the steam oxidation method, the silicon oxide film grows faster than that according to a dry oxidation method in the thermal oxidation treatment. Accordingly, the silicon oxide film having a desired thickness can be more efficiently formed.

The silicon oxide film formed on the front surface of the escape gear portion 101 formed of the material containing silicon improves the mechanical strength of the escape gear portion 101. Through the operation described below, fitting strength between the escape gear portion 101 serving as the rotation member and the axle member 102 can be improved in the escape wheel 35 serving as the mechanical component. That is, the axle member 102 is positioned by being inserted into the holding portion 115 of the escape gear portion 101, and thereafter, the oxidation treatment is performed. In this manner, the silicon oxide film formed on the front surface of the escape gear portion 101 is formed so as to fill the clearance between the projection portion 112 and the axle member 102 in the vicinity of the contact portion between the projection portion 112 of the holding portion 115 and the axle member 102. In this manner, the press-fitted axle portion 123 of the axle member 102 is fitted to the holding portion 115. Therefore it is possible to provide the escape wheel 35 serving as the mechanical component in which the axle member 102 is firmly fixed to the escape gear portion 101.

In addition, the axle member 102 formed by means of machining such as cutting and grinding has irregularities such as minute scratches on the front surface. Accordingly, the silicon oxide film of the escape gear portion 101 enters the irregularities, thereby achieving a so-called anchoring effect. Therefore, an advantageous effect can be obtained in that the axle member 102 is more firmly fixed to the holding portion 115 of the escape gear portion 101.

Through the steps up to the above-described oxidation treatment step, a series of method of manufacturing the escape wheel 35 serving as the mechanical component is completed.

According to the manufacturing method of the escape wheel 35 (the mechanical component) in the above-described embodiment, the following advantageous effects can be obtained.

According to the embodiment, the axle member 102 is positioned by being inserted into the holding portion 115 of the escape gear portion 101 serving as the rotation member formed of the base material 200 containing silicon. Thereafter, oxidation treatment for forming the silicon oxide film is performed on the front surface of the escape gear portion 101. Accordingly, the clearance between the projection portion 112 and the axle member 102 is filled with the silicon oxide film formed in the projection portion 112 of the holding portion 115. In this manner, it is possible to provide the escape wheel 35 serving as the mechanical component in which the axle member 102 is firmly fitted / fixed to the escape gear portion 101.

In addition, in the above-described embodiment, the base material 200 formed of the material containing silicon is processed using a standard photolithography technology and etching. In this manner, through relatively simple steps, the escape wheel 35 which is a precise mechanical component can be manufactured at low cost.

In addition, at least a portion of the precise mechanical component such as the escape gear portion 101 formed through the processing of the base material 200 containing silicon by using the manufacturing method according to the embodiment is lighter in weight than the metallic mechanical component, and the shape is freely designed. Accordingly, an advantageous effect is achieved in that the outer shape can be very accurately formed.

Furthermore, an advantageous effect can be obtained in that the mechanical strength of the escape gear portion 101 formed of the base material 200 containing relatively fragile silicon is remarkably improved by the silicon oxide film formed through the step of performing the oxidation treatment (thermal oxidation treatment using the steam oxidation method).

In addition, the manufacturing method of the mechanical component according to the above-described embodiment is configured to include relatively simple steps using the standard photolithography or oxidation treatment. Accordingly, it is possible to provide the manufacturing method by which the escape wheel 35 serving as the mechanical component can be obtained with high yield at low cost.

### Embodiment 2

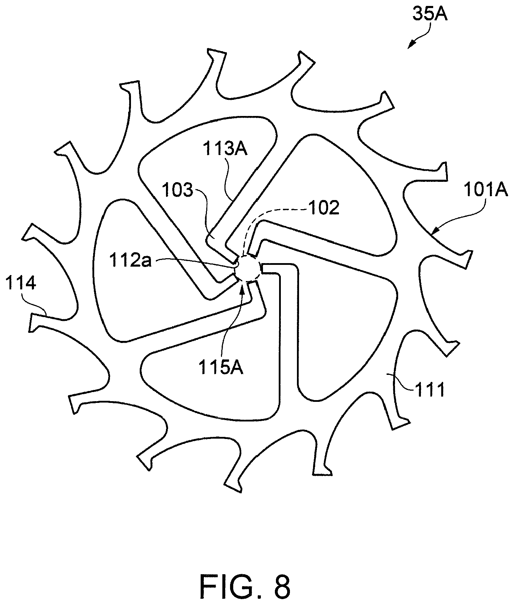

Fig. 8 is a plan view illustrating an escape wheel 35A serving as a mechanical component according to Embodiment 2. The same reference numerals will be given to the same configurations as those according to Embodiment 1, and repeated description will be omitted. In addition, in Fig. 8, in order to facilitate the description of a configuration of a characteristic escape gear portion 101A serving as a rotation member in the escape wheel 35A according to the embodiment, only a portion fitted to the escape gear portion 101A in the axle member 102 is illustrated using a broken line.

The escape gear portion 101A of the escape wheel 35A according to the embodiment illustrated in Fig. 8 has a rim portion 111 having a plurality of tooth portions 114 located on the peripheral edge side, and a plurality of spoke-like elastic portions 113A which extend from the rim portion 111 to a holding portion 115A side at the center of the escape gear portion 101A so as to hold the axle member 102. In the embodiment, the escape gear portion 101A has five elastic portions 113A.

The elastic portion 113A extending from the rim portion 111 to the holding portion 115A side at the center has a bend portion 103 on the holding portion 115A side, and has a holding end portion 112a for holding the axle member 102 on the distal end side of the bend portion 103. In the embodiment, the bend portion 103 is bent substantially at a right angle, and the holding end portion 112a from the bend portion 103 is narrower than the rim portion 111 side from the bend portion 103. In addition, the diameter of the circumscribed circle passing through each top of the plurality of holding end portions 112a for holding the axle member 102 in the holding portion 115A is designed to be smaller than the diameter of the axle member 102.

The escape wheel 35A having the axle member 102 fixed to the escape gear portion 101A according to the embodiment can be manufactured using the same manufacturing steps as those in the manufacturing method of the escape wheel 35 according to Embodiment 1 described above.

According to the configuration of the escape gear portion 101A (escape wheel 35A) in Embodiment 2, when the axle member 102 is held by a holding structure having the plurality of elastic portions 113A extending from the rim portion 111, the stress applied to the holding portions 115A (plurality of holding end portions 112a) of the escape gear portion 101A is relaxed by the elasticity of the elastic portions 113A. In particular, the elastic portion 113A according to the embodiment has the bend portion 103 on the holding portion 115A side. Accordingly, in the elastic portion 113A, the elastic portion between the bend portion 103 and the rim portion 111 (that is, the elastic portion ahead of the bend portion) is deformed. Therefore, the stress applied to the holding portion 115A when the axle member 102 is held can be relaxed by the elastic portion 113A deformed in the bend portion 103.

Therefore, it is possible to provide the escape wheel 35A serving as the mechanical component in which while suppressing damage such as breakage of the holding portion 115A caused by the stress when the axle member 102 is held by being inserted into the holding portion 115A of the escape gear portion 101A, the axle member 102 is held in the escape gear portion 101A with the suitable holding power.

The invention is not limited to the above-described embodiments, and various modifications and improvements can be added to the above-described embodiments. Hereinafter, modification examples of the escape wheel 35 (mechanical component) according to the above-described embodiments will be described.

### Modification Example 1

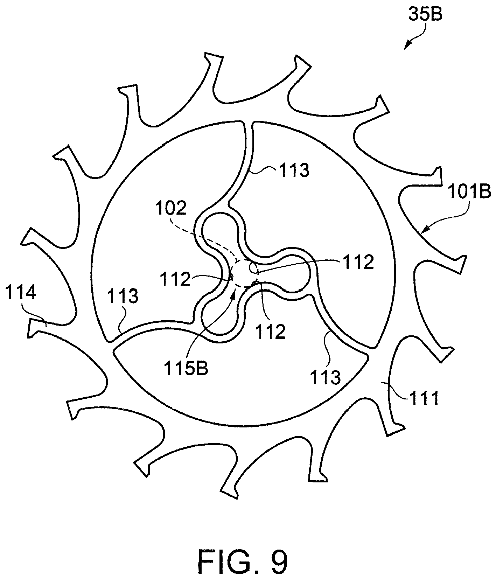

Fig. 9 is a plan view illustrating an escape wheel 35B according to Modification Example 1. In Fig. 9, the same reference numerals will be given to configurations the same as those according to the above-described embodiment, and repeated description will be omitted. In the axle member 102, only a portion fitted to an escape gear portion 101B is illustrated using a broken line.

In Fig. 9, the escape gear portion 101B of the escape wheel 35B according to Modification Example 1 has the rim portion 111 located on the peripheral edge side and a plurality of spoke-like elastic portions 113 extending from the rim portion 111 to a holding portion 115B at the center.

In addition, the holding portion 115B for holding the axle member 102 has a configuration including a plurality of projection portions 112 the same as the holding portions 115 (refer to Fig. 5) of the escape gear portion 101 according to the above-described embodiment 1. Then, each of the elastic portions 113 extends radially in an arc shape toward the inner peripheral edge of the rim portion 111 from between the projection portions 112 adjacent to each other in the holding portion 115B, and connects the rim portion 111 and the holding portion 115B to each other. Here, the elastic portion 113 in the escape gear portion 101B according to this modification example is configured to have one elastic portion 113 in the two arc-shaped elastic portions 113 (refer to Fig. 5) which dually extend toward the rim portion 111 from between the projection portions 112 adjacent to each other in the holding portion 115 according to Embodiment 1 described above.

According to the configuration of the escape gear portion 101B (escape wheel 35B) in this modification example, when the axle member 102 is held by a holding structure having the plurality of arc-shaped elastic portions 113 connecting the rim portion 111 and the holding portion 115B to each other, the stress applied to the holding portion 115B of the escape gear portion 101B is relaxed by the elastic portion 113. Here, the elastic portion 113 according to this modification example is configured so that only the half number of arc-shaped elastic portions 113 according to Embodiment 1 described above is disposed. Accordingly, the elastic portion 113 is much more likely to be deformed. Therefore, an advantageous effect can be obtained in that the stress applied to the holding portion 115B when holding the axle member 102 is more likely to be relaxed.

### Modification Example 2

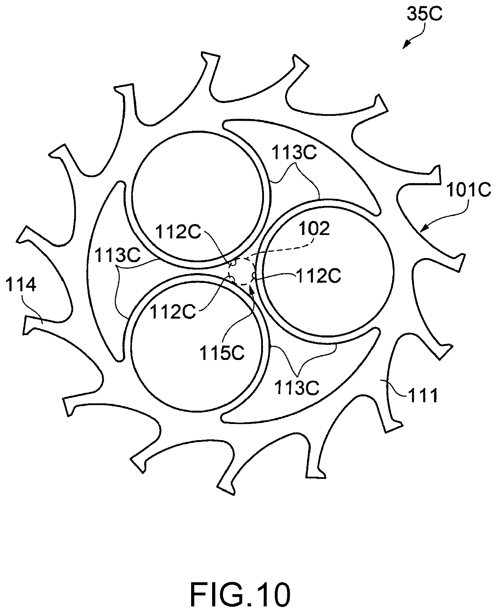

Fig. 10 is a plan view illustrating an escape wheel 35C according to Modification Example 2. In Fig. 10, the same reference numerals will be given to configurations the same as those according to the above-described embodiment, and repeated description will be omitted. In an axle member 102, only a portion fitted to an escape gear portion 101C is illustrated using a broken line.

In Fig. 10, the escape gear portion 101C of the escape wheel 35C according to Modification Example 2 has the rim portion 111 located on the peripheral edge side, and a plurality of arc-shaped elastic portions 113C which extend from the rim portion 111 to a holding portion 115C side at the center of an escape gear portion 101C so as to hold the axle member 102. The elastic portions 113C according to this modification example extend in an arc shape from six locations of the rim portion 111 to the center. The elastic portions 113C adjacent to each other in the rim portion 111 are connected to each other at the center, thereby forming a combination of the three circular elastic portions 113C. At the center of the escape gear portion 101C, the holding portion 115C having three holding portions 112C for holding the axle member 102 is configured to include the combination of the three circular elastic portions 113C. In the holding portion 115C, the diameter of the circumscribed circle passing through the top of the three holding portions 112C for holding the axle member 102 is designed to be smaller than the diameter of the axle member 102.

According to the configuration of the escape gear portion 101C (escape wheel 35C) in this modification example, when the axle member 102 is held by a holding structure having the plurality of circular (arc-shaped) elastic portions 113C extending from the rim portion 111 and connected to each other at the center portion, the stress applied to the holding portion 115C (holding portion 112C) of the escape gear portion 101C is relaxed by the arc-shaped elastic portions 113C. In this manner, while damage such as breakage of the holding portion 115C is suppressed, the axle member 102 can be held by the holding portion 115C by using the elasticity of the elastic portion 113C.

### Modification Example 3

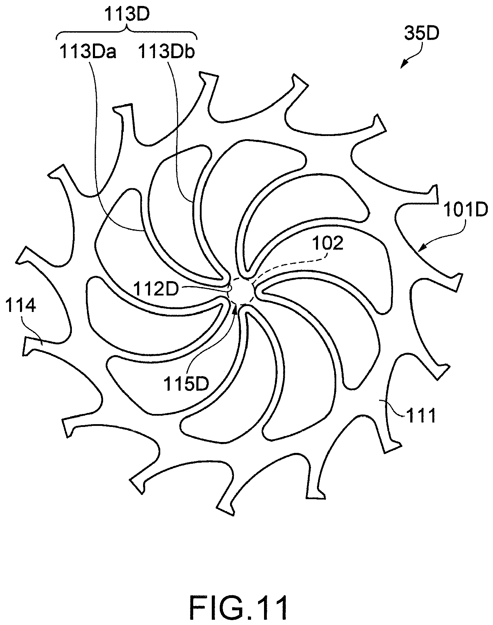

Fig. 11 is a plan view illustrating an escape wheel 35D according to Modification Example 3. In Fig. 11, the same reference numerals will be given to configurations the same as those according to the above-described embodiment, and repeated description will be omitted. In the axle member 102, only a portion fitted to an escape gear portion 101D is illustrated using a broken line.

In Fig. 11, the escape gear portion 101D of an escape wheel 35D according to Modification Example 3 has the rim portion 111 located on the peripheral edge side, and a plurality of arc-shaped elastic portions 113D which extend from the rim portion 111 to a holding portion 115D at the center of the escape gear portion 101D so as to hold the axle member 102. The elastic portion 113D according to this modification example has a configuration different from the configuration according to Modification Example 2 in which the elastic portions 113C adjacent to each other in the rim portion 111 are connected to each other at the center so as to form a plurality of combinations of circular elastic portions 113C (refer to Fig. 10). An elastic portion 113Da and an elastic portion 113Db adjacent to each other in the rim portion 111 extend in an arc shape in the same direction toward the holding portion 115D side at the center, and the elastic portion 113D is configured to have a plurality of combinations of the elastic portions 113Da and 113Db connected to each other at the center. This modification example has five elastic portions 113D including the combination of the elastic portion 113Da and the elastic portion 113Db. A connection portion of the combination of the elastic portion 113Da and the elastic portion 113Db of each elastic portions 113D serves as five holding portions 112D for holding the axle member 102, thereby configuring the holding portion 115D in the escape gear portion 101D. The diameter of the circumscribed circle passing through the top of the five holding portions 112D for holding the axle member 102 in this holding portion 115D is designed to be smaller than the diameter of the axle member 102.

According to the configuration of the escape gear portion 101D (escape wheel 35D) in this modification example, when the axle member 102 is held by a holding structure having the elastic portion 113D including the combination of the plurality of arc-shaped elastic portions 113Da and elastic portions 113Db which extend from the rim portion 111 and which are connected to each other at the center, the stress applied to the holding portion 115D of the escape gear portion 101D is relaxed by the elasticity of the elastic portion 113D. While damage such as breakage of the holding portion 115D is suppressed, the axle member 102 can be held with the suitable holding power.

### Modification Example 4

In the above-described embodiment, an example has been described in which tantalum or tungsten is preferably used as the material of the axle member 102. However, the example is not limited thereto. A configuration may be adopted in which a material containing silicon is used as the material of the axle member 102.

According to this configuration, the axle member 102 is positioned by being inserted into the holding portion 115 of the escape gear portion 101. Thereafter, through the step of performing oxidation treatment, the silicon oxide film is formed not only on the front surface (front surface 200a and rear surface 200b) including the inner wall surface (side where the projection portion 112 is in contact with the axle member 102) of the holding portion 115 of the escape gear portion 101 serving as the rotation member, but also on the front surface of the axle member 102. Accordingly, the axle member 102 can be more firmly fixed to the holding portion 115 of the escape gear portion 101 serving as the rotation member within a shorter time.

### Modification Example 5

In the above-described embodiment, an example has been described in which tantalum or tungsten is preferably used as the material of the axle member 102. However, the example is not limited thereto. A configuration may be adopted in which the material containing carbon steel is used as the material of the axle member 102. In addition, the silicon oxide film may be formed in advance on the front surface of the escape wheels 35 and 35A to 35D, and thereafter, the axle member 102 may be inserted. Even in a case where the silicon oxide film is not formed on the front surface of the escape wheel 35 and 35 A to 35 D, or even in a case where the escape wheels 35 and 35A to 35D are formed of metal, regardless of the presence or absence of the oxide film, the axle member 102 can be held with the suitable holding power by the above-described elastic portion.

### Manufacturing Method of Mechanical Timepiece

Next, a manufacturing method of the mechanical timepiece according to the invention will be described.

The manufacturing method of the mechanical timepiece according to the invention includes an assembly step of assembling the movement 10 by using the mechanical component manufactured using any one manufacturing method of the mechanical component described as a representative example of the escape gear portion 101 according to the above-described embodiments and modification examples for any one of the barrel wheel 22, wheels & pinion (the center wheel & pinion 25, the third wheel & pinion 26, and the second wheel & pinion 27), the escape wheel 35, the pallet fork 36, and the balance 40 which are illustrated in any one of Figs. 1 to 5.

According to the manufacturing method of the mechanical timepiece, the manufacturing method includes the step of assembling the movement 10 by using the mechanical component manufactured using the manufacturing method of the mechanical component described in the above-described embodiments and modification examples. Accordingly, the movement 10 in which energy transmission efficiency is improved can be configured to include the mechanical component which is lighter in weight than a metallic mechanical component and for which the inertial force is minimized.

In addition, the mechanical component is used where the center of the through-hole of the rotation member in the mechanical component and the axial center of the axle member coincide with each other, such as the holding portion 115 of the escape gear portion 101 and the axle member 102 in the escape wheel 35 according to the above-described embodiments. Accordingly, the mechanical component can contribute to the improved accuracy of the movement for the timepiece.

Therefore, it is possible to provide the more accurate mechanical timepiece which achieves excellent reliability and durability.

Hitherto, the embodiments according to the invention made by the inventor have been described in detail. However, the invention is not limited to the above-described embodiments, and various modifications can be added without departing from the gist of the invention.

For example, in the above-described embodiment, as the manufacturing method of the escape wheel 35 serving as a mechanical component, a configuration has been described in which after the positioning step of inserting the axle member 102 into the holding portion 115 of the escape gear portion 101 serving as the rotation member is performed, the oxidation treatment for forming the silicon oxide film on the front surface of the escape gear portion 101 is performed. However, the invention is not limited thereto. In the positioning step where the mechanical strength of the escape gear portion 101 is sufficiently ensured in a state without performing the oxidation treatment, as long as the holding power of the axle member 102 held by the holding portion 115 of the escape gear portion 101 can be sufficiently ensured, a configuration without performing the oxidation treatment may be adopted.

In addition, in the above described embodiments and modification examples, an example has been described in which the material of the axle member 102 of the escape wheel 35 serving as the mechanical component is preferably formed of tantalum (Ta), tungsten (W), or silicon. However, the material is not limited thereto. A material having heat resistance against the temperature of the thermal oxidation treatment using the steam oxidation method in a step of performing the oxidation treatment for a subsequent step, or other materials may be used.

## Claims

1. A mechanical component comprising:
an axle member; and
a rotation member that has a holding portion for holding the axle member, and a rim portion having a plurality of tooth portions,
wherein the holding portion has a plurality of proj ection portions formed to project into a through-hole into which the axle member is inserted, and
wherein an elastic portion extending from between the projection portions adjacent to each other is provided between the holding portion and the rim portion.

2. A mechanical component comprising:
an axle member; and
a rotation member that has a rim portion having a plurality of tooth portions,
wherein the rotation member has plurality of elastic portions which extend from the rim portion so as to hold the axle member.

3. The mechanical component according to claim 1 or claim 2,
wherein the elastic portion is formed of the same material as that of the rotation member.

4. The mechanical component according to claim 3,
wherein the same material contains silicon.

5. The mechanical component according to any of claims 1-4,
wherein the elastic portion is formed in an arc shape.

6. The mechanical component according to any of claims 2-4,
wherein the elastic portion has a bend portion.

7. The mechanical component according to any of claims 4-6,
wherein an oxide film is formed on a front surface of the rotation member.

8. A timepiece comprising:
a movement assembled using the mechanical component according to any of claims 1-7 for any one of a barrel wheel, wheel & pinions, an escape wheel, a pallet fork, and a balance.

9. A manufacturing method of a mechanical component, comprising:
preparing an axle member;
performing etching on a base material containing silicon, and forming a rotation member that has a holding portion having a plurality of projection portions arranged so as to project to a through-hole into which the axle member is inserted, a rim portion having a plurality of tooth portions, and an elastic portion extending from between the projection portions adjacent to each other, between the holding portion and the rim portion; and
positioning the axle member by inserting the axle member into the holding portion of the rotation member.

10. A manufacturing method of a mechanical component, comprising:
preparing an axle member;
performing etching on a base material containing silicon, and forming a rotation member that has a rim portion having a plurality of tooth portions, and a plurality of elastic portions extending from the rim portion so as to hold the axle member; and
positioning the axle member by inserting the axle member into the holding portion of the rotation member.

11. The manufacturing method of a mechanical component according to claim 9 or claim 10, further comprising:
performing oxidation treatment after the positioning.

12. The manufacturing method of a mechanical component according to claim 11,
wherein in performing the oxidation treatment, thermal oxidation treatment is performed.

13. The manufacturing method of a mechanical component according to claim 12,
wherein the thermal oxidation treatment is performed using a steam oxidation method.

14. The manufacturing method of a mechanical component according to claim 9, 12 or claim 13,
wherein the axle member is formed of tantalum (Ta) or tungsten (W).

15. The manufacturing method of a mechanical component according to any of claims 11-14,
wherein the axle member is formed of a material containing silicon.

16. A manufacturing method of a timepiece, comprising:
assembling a movement by using a mechanical component manufactured using the manufacturing method of the mechanical component according to any of claims 9-15 for any one of a barrel wheel, wheel & pinions, an escape wheel, a pallet fork, and a balance.
